# EUROPÄISCHE PATENTANMELDUNG

(11) **EP 2 184 853 A2**
(43) Veröffentlichungstag der Anmeldung: **12.05.2010**
(21) Anmeldenummer: 09011302.8
(22) Anmeldetag: 03.09.2009
(51) Int. Cl.: H03K 3/356, H03K 19/0185

(54) **Pegelschieber mit Kaskodenschaltung und dynamischer Toransteuerung**

(30) Priorität: 06.11.2008 DE 102008056130
(71) Anmelder: Micronas GmbH, 79108 Freiburg (DE)
(72) Erfinder: Czech, Martin, 79427 Eschbach (DE); Giehl, Jürgen, 79199 Kirchzarten (DE); Theus, Ulrich Dr., 79194 Gundelfingen (DE)
(74) Vertreter: Göhring, Robert

(57) **Zusammenfassung**

Pegelschieber zum Umsetzen eines Eingangssignals (in) aus einem ersten Betriebsspannungsbereich (I) mit einem ersten Grundpotential (VSS1) und einem ersten Betriebspotential (VDD1) in ein Ausgangssignal out in einem zweiten Betriebsspannungsbereich (II) mit einem zweiten Grundpotential (VSS2) und einem zweiten Betriebspotential (VDD2) mit einer Eingangsschaltung (1) an die das Eingangssignal (in) anlegbar ist und einer Ausgangsschaltung (2) an der das Ausgangssignal (out) abgreifbar ist, wobei die Eingangsschaltung (1) eine Parallelschaltung aus einer ersten Kaskode-Schaltung (10) und eine zweiten Kaskode-Schaltung (20) aufweist und die Kaskode-Schaltungen (10, 20) je aus einem ersten Transistor (T11, T21) in Source-Schaltung und einem zweiten Transistor (T12, T22) in Gate-Schaltung aufgebaut sind, wobei eine dynamische Ansteuerung für die zweiten Transistoren (T12, T22) vorgesehen ist.

## Beschreibung

Die Erfindung betrifft einen Pegelschieber gemäß dem Oberbegriff des Patentanspruchs 1.

Derartige Pegelschieber sind aus dem Stand der Technik beispielsweise aus der DE 10 2004 052 092 A1 zum Umsetzen eines Eingangssignals in aus einem ersten Betriebsspannungsbereich I mit einem ersten Grundpotential VSS1 und einem ersten Versorgungspotential VDD1 in ein Ausgangssignal out in einem zweiten Betriebsspannungsbereich II mit einem zweiten Grundpotential VSS2 und einem zweiten Versorgungspotential VDD2 bekannt.

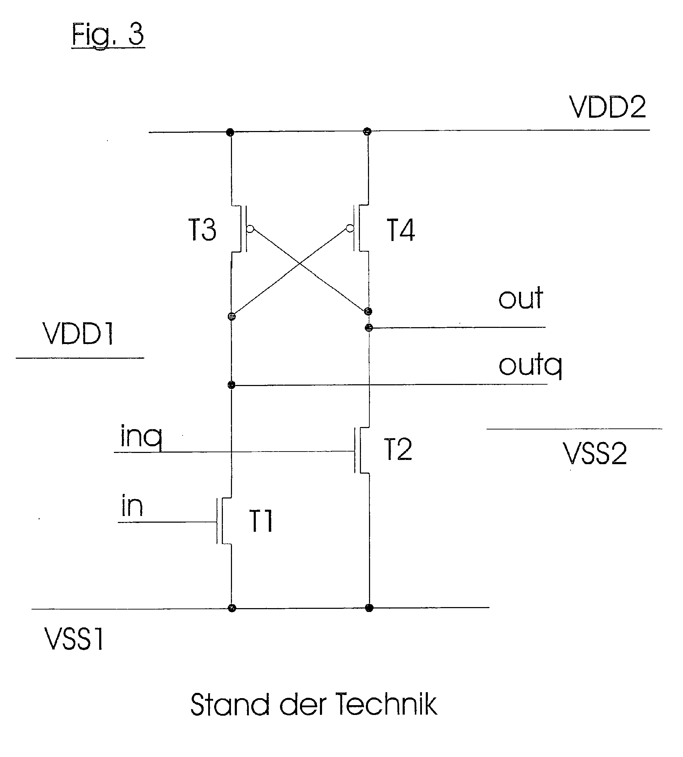

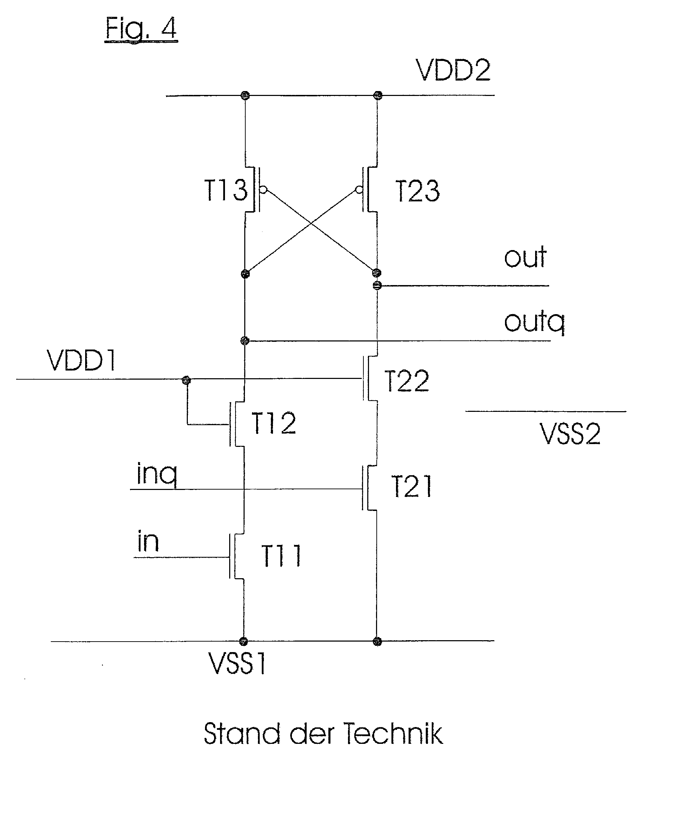

Aus dem Stand der Technik bekannte Pegelschieber sind beispielhaft in den Figuren 3 und 4 dargestellt.

Der Pegelschieber in Figur 3 ist als eine Parallelschaltung einer Reihenschaltung eines ersten Eingangstransistors T1 und eines ersten Ausgangsstransistors T3 mit einer Reihenschaltung eines zweiten Eingangstransistors T2 und eines zweiten Ausgangstransistors T4 aufgebaut und zur Versorgung zwischen das erste Grundpotential VSS1 und das zweite Versorgungspotential VDD2 geschaltet. Der erste Ausgangstransistor T3 und der zweite Ausgangstransistor T4 sind kreuzverkoppelt, d.h. ein Steuereingang des ersten Ausgangstransistors T3 ist mit einem Verbindungspunkt zwischen dem zweiten Eingangstransistor T2 und dem zweiten Ausgangstransistor T4 verbunden und ein Steuereingang des zweiten Ausgangstransistors T4 ist mit einem Verbindungspunkt zwischen dem ersten Eingangstransistor T1 und dem ersten Ausgangstransistor T3 verbunden. Einem Steuereingang des ersten Eingangstransistors T1 ist das Eingangssignal in direkt zuführbar, während es einem Steuereingang des zweiten Eingangstransistors T2 als invertiertes Eingangssignal inq zuführbar ist. An dem Verbindungspunkt zwischen dem zweiten Eingangstransistor T2 und dem zweiten Ausgangstransistor T4 ist ein Ausgangssignal out abgreifbar, während an dem Verbindungspunkt zwischen dem ersten Eingangstransistor T1 und dem ersten Ausgangstransistor T3 ein invertiertes Ausgangssignal outq abgreifbar ist.

Wird eingangsseitig beispielsweise ein high-Signal angelegt, so schaltet der erste Eingangstransistor T1 in einen leitenden Zustand und zieht den nachfolgenden Verbindungspunkt auf das erste Grundpotential VSS1. Der zweite Eingangstransistor T2, dem das invertierte high-Signal, also ein low-Signal, zugeführt wird, sperrt. Das an dem Verbindungspunkt zwischen dem ersten Eingangstransistor T1 und dem ersten Ausgangstransistor T3 anliegende erste Grundpotential VSS1 schaltet den zweiten Ausgangstransistor T4, der als p-Kanal-Transistor ausgebildet ist, in einen leitenden Zustand, so dass der Verbindungspunkt zwischen dem zweiten Eingangstransistor T2 und dem zweiten Ausgangstransistor T4 auf das zweite Versorgungspotential VDD2 angehoben wird. Durch das an dem Verbindungspunkt anliegende Potential wird der erste Ausgangstransistor T3, der ebenfalls als p-Kanal-Transistor ausgebildet ist, in einen sperrenden Zustand gebracht. Ausgangsseitig ist somit an dem Verbindungspunkt zwischen dem zweiten Eingangstransistor T2 und dem zweiten Ausgangstransistor T4 ein high-Signal, nämlich das zweite Versorgungspotential VDD2, als Ausgangssignal out abgreifbar. An dem Verbindungspunkt zwischen dem ersten Eingangstransistor T1 und dem ersten Ausgangstransistor T3 ist ausgangsseitig ein low-Signal, nämlich das erste Grundpotential VSS1, als invertiertes Ausgangssignal outq abgreifbar.

Liegt der erste Betriebsspannungsbereich I beispielsweise in einem Bereich von 0 bis 3 V und der zweite Betriebsspannungsbereich II in einem Bereich von 7 bis 12 V, so ist es außerdem notwendig, wie in Figur 4 dargestellt, den Eingangstransistor T1, T2 je durch eine Kaskode-Schaltung aus einem ersten Transistor T11, T21 und einem zweiten Transistor T12, T22 zum Überspannungsschutz zu ersetzen. Die Steuereingänge der zweiten Transistoren T12, T22 sind mit dem ersten Versorgungspotential VDD1 verbunden, so dass die beiden als n-Kanal-Transistor ausgebildeten zweiten Transistoren T12, T22 dauerhaft in einem leitenden Zustand sind. Die beiden ersten Transistoren T11, T21 sind technologisch derart beschaffen, dass sie die hohe Potentialdifferenz zwischen dem ersten Grundpotential VSS1 und dem zweiten Versorgungspotential VDD2 nicht unbeschadet überstehen. Durch die zweiten Transistoren T12, T22 wird dieser Nachteil behoben.

Ist bei einem Pegelschieber nach dem Stand der Technik eine Potentialdifferenz des ersten Betriebsspannungsbereiches I so klein, dass eine resultierende effektive Gatespannung Veff_{G} in der Nähe der Schwellspannung Vₜₕ der Eingangstransistoren T11 und T21 liegt, und kommen aufgrund einer großen Potentialdifferenz des zweiten Betriebsspannungsbereichs II keine Transistoren mit einer niedriger liegenden Schwellspannung Vₜₕ, die durch ein dünneres Gate-Oxid und eine angepasste Kanaldotierung erreicht wird, in Frage, so werden die aus dem Stand der Technik bekannten Pegelschieber nicht mehr funktionieren, da die effektive Gatespannung der Kasoden-Transistoren T12, T22 nicht mehr ausreichend groß ist. Die effektive Gate-Spannung Veff_{G} ist dabei als Differenz zwischen einer tatsächlich anliegenden Gate-Source-Spannung V_{GS} und der Schwellspannung Vₜₕ eines Transistors definiert.

Es ist die Aufgabe der vorliegenden Erfindung, einen Pegelschieber zur Verfügung zu stellen, der die Nachteile aus dem Stand der Technik nicht aufweist und auch bei einer geringen Potentialdifferenz im ersten Betriebsspannungsbereich I und einer großen Potentialdifferenz im zweiten Betriebsspannungsbereich II zuverlässig arbeitet.

Diese Aufgabe wird durch einen Pegelschieber mit den Merkmalen des Patentanspruchs 1 gelöst. Vorteilhafte Weiterbildungen der Erfindung sind Gegenstand von Unteransprüchen.

Ein erfindungsgemäßer Pegelschieber zum Umsetzen eines Eingangssignals aus einem ersten Betriebsspannungsbereich mit einem ersten Grundpotential und einem ersten Betriebspotential in ein Ausgangssignal in einem zweiten Betriebsspannungsbereich mit einem zweiten Grundpotential und einem zweiten Betriebspotential weist eine Eingangsschaltung und eine Ausgangsschaltung auf, wobei an die Eingangsschaltung das Eingangssignal anlegbar ist und das Ausgangssignal an der Ausgangsschaltung abgreifbar ist. Die Eingangsschaltung ist dabei als eine Parallelschaltung aus einer ersten Kaskode-Schaltung und einer zweiten Kaskode-Schaltung aufgebaut, wobei die Kaskode-Schaltungen je aus einem ersten Transistor in Source-Schaltung und einem zweiten Transistor in Gate-Schaltung aufgebaut sind. Darüber hinaus weist der erfindungsgemäße Pegelschieber eine dynamische Ansteuerung für die zweiten Transistoren auf.

Durch die Verwendung einer dynamischen Toransteuerung für die zweiten Transistoren ist es möglich, dass die zweiten Transistoren in einem Fertigungsprozess entsprechend der Anforderungen für den zweiten Betriebsspannungsbereich ausgelegt werden können, wobei durch die dynamische Toransteuerung erreicht wird, dass die zweiten Transistoren trotz einer geringen Potentialdifferenz des ersten Betriebsspannungsbereichs in einen leitenden Zustand gebracht werden können.

Eine derartige dynamische Toransteuerung kann beispielsweise durch eine Kapazität erreicht werden, die jeweils zwischen einem Steueranschluss des ersten Transistors und einem Steueranschluss des zweiten Transistors angeordnet ist.

Bei Anliegen eines Signals an dem ersten Transistor werden je nach Ausprägung des Signals Ladungen von der Kapazität zum Steuereingang des zweiten Transistors geschoben oder entsprechend vom Steuereingang des zweiten Transistors auf die Kapazität gezogen. Bei Anliegen eines high-Signals werden also die entsprechenden Ladungen von der Kapazität auf den Steueranschluss des zweiten Transistors bewegt, so dass dort kurzzeitig ein erhöhtes Potential anliegt, das ausreicht, um den zweiten Transistor in einen leitenden Zustand zu versetzen.

Um einen zu schnellen Ladungsausgleich auf das erste Betriebspotential zu verhindern, kann zwischen dem Steueranschluss des jeweils zweiten Transistors und dem ersten Betriebspotential je ein Widerstand angeordnet sein. Zur Verhinderung von spannungsinduzierten Defekten, die durch ein zu hohes bzw. zu niedriges Potential am Steuereingang des zweiten Transistors auftreten können, kann parallel zu dem Widerstand eine Klemmschaltung angeordnet sein, die auf das erste Betriebspotential klemmt. Diese Klemmschaltung kann beispielsweise durch zwei antiparallel geschaltete Dioden oder zwei als Dioden geschaltete Transistoren realisiert sein.

Die erfindungsgemäße dynamische Toransteuerung kommt bevorzugt bei Pegelschiebern zum Einsatz bei denen die ersten Transistoren für den ersten Betriebsspannungsbereich und die zweiten Transistoren für den zweiten Betriebsspannungsbereich geeignet sind. Die Eignung der Transistoren für den ersten bzw. zweiten Betriebsspannungsbereich bedingt die technologische Dimensionierung der jeweiligen Transistoren, d.h. dass die Transistoren für den ersten Betriebsspannungsbereich mit einem dünneren Gate-Oxid und einer niedrigeren Schwellspannung ausgestattet sind, als diejenigen für den zweiten Betriebsspannungsbereich. Dies hat jedoch zur Folge, dass die ersten Transistoren eine hohe Potentialdifferenz zwischen dem zweiten Versorgungspotential und dem ersten Grundpotential nicht unbeschadet überstehen. Wenn zum Überspannungsschutz der ersten Transistoren die in Kaskode geschalteten zweiten Transistoren vorgesehen sind, die derart ausgelegt sind, dass sie die Potentialdifferenz des zweiten Betriebsspannungsbereichs unbeschadet überstehen, hat dies zur Folge, dass die zweiten Transistoren mit einem dickeren Gate-Oxid sowie einer erhöhten Schwellspannung dimensioniert sein müssen. Durch die dynamische Toransteuerung kann eine effektive Gate-Spannung an den zweiten Transistoren erreicht werden, die ausreichend groß ist, damit diese in einen leitenden Zustand versetzt werden. Die effektive Gate-Spannung ist dabei als Differenz einer an dem Transistor anliegenden Gate-Source-Spannung und einer Schwellspannung des Transistors definiert.

Um definierte Eingangs- und Ausgangssignale für den Pegelschieber bereitzustellen, können sowohl am Eingang als auch am Ausgang des Pegelschiebers Inverter vorgesehen sein.

Die Kapazitäten der dynamischen Toransteuerung können beispielsweise durch Gate-Kapazitäten von MOS-Transistoren oder durch Metallfinger- oder MIM-Kondensatoren gebildet sein. Die Gate-Kapazitäten von MOS-Transistoren haben den Vorteil, dass sie einen hohen Kapazitätsbelag pro Fläche aufweisen. Metallfinger- oder MIM-Kondensatoren sind entsprechend mit höherem Flächenbedarf verknüpft.

Die Widerstände der dynamischen Toransteuerung können beispielsweise durch Polysilizium-, Diffusions- oder Wannen-Widerstände gebildet sein, wobei Polysilizium-Widerstände den Vorteil aufweisen, dass sie von Substrat entkoppelt sind.

Zum Schutz gegen elektrostatische Zerstörungen können die Eingangsschaltung und/oder die Ausgangsschaltung verschiedene Schutzschaltungen aufweisen.

Beispielsweise kann zur Verhinderung von zu großen Spannungen zwischen dem ersten Grundpotential und dem zweiten Grundpotential eine Schaltung aus zwei antiparallel geschalteten Klemmdioden oder entsprechend als Diode geschalteten Transistoren vorgesehen sein. Des Weiteren kann eine Potentialdifferenz des ersten Betriebsspannungsbereichs durch eine erste Betriebsspannungs-Klemmschaltung und eine Potentialdifferenz des zweiten Betriebsspannungsbereichs durch eine zweite Betriebsspannungs-Klemmschaltung begrenzt sein, die jeweils zwischen dem Grundpotential und dem Versorgungspotential angeordnet ist. Das Ausgangssignal kann des Weiteren durch Klemmdioden oder als Diode geschaltete Transistoren auf den zweiten Betriebsspannungsbereich beschränkt werden, so dass am Ausgang keine zerstörerischen Spannungen anliegen können. Außerdem können zwischen der Eingangsschaltung und der Ausgangsschaltung weitere Widerstände zur Strombegrenzung angeordnet sein.

Ein erfindungsgemäßer Pegelschieber wird anschließend unter Bezugnahme auf die beigefügten Figuren eingehend erläutert.

### Es zeigen:

- Figur 1: einen erfindungsgemäßen Pegelschieber mit Kaskode-Schaltungen und dynamischer Toransteuerung,
- Figur 2: typische Spannungsverläufe beim Umschalten von einem low- zu einem high-Pegel an einem erfindungsgemäßen Pegelschieber,
- Figur 3: einen Pegelschieber nach dem Stand der Technik (schon behandelt) und
- Figur 4: einen Pegelschieber nach dem Stand der Technik mit Kaskode-Schaltung (schon behandelt).

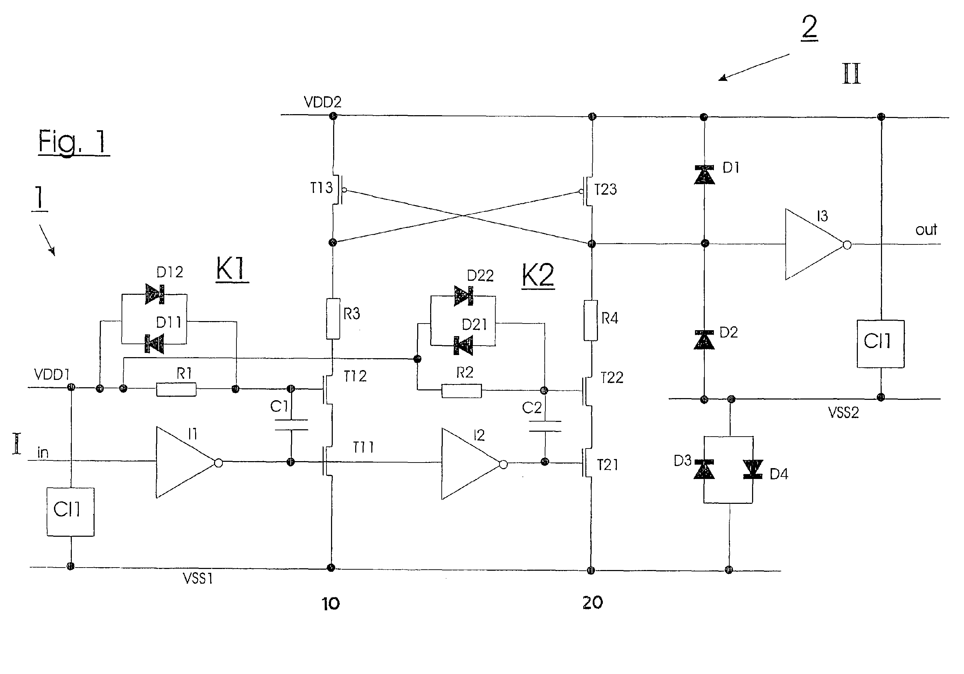

Figur 1 zeigt einen Pegelschieber mit einer Eingangsschaltung 1 und einer Ausgangsschaltung 2 zum Umsetzen eines Eingangssignals in aus einem ersten Betriebsspannungsbereich I in ein Ausgangssignal out in einem zweiten Betriebsspannungsbereich II. Der erste Betriebsspannungsbereich I weist dabei ein erstes Grundpotential VSS1 und ein erstes Betriebspotential VDD1 auf. Der zweite Betriebsspannungsbereich II entsprechend ein zweites Grundpotential VSS2 und ein zweites Betriebspotential VDD2. Die Eingangsschaltung 1 ist als Parallelschaltung einer ersten Eingangsstufe 10 und einer zweiten Eingangsstufe 20 aufgebaut, die jeweils als Kaskode-Schaltung aus einem ersten Transistor T11, T21 in Source-Schaltung in einem zweiten Transistor T12, T22 in Gate-Schaltung aufgebaut sind. Die Eingangsstufen 10, 20 weisen des Weiteren je eine dynamische Toransteuerung zur Ansteuerung eines Steuereingangs der zweiten Transistoren T12, T22 auf. Die dynamische Toransteuerung ist jeweils durch eine Kapazität C1, C2 realisiert, die jeweils zwischen einem Steuereingang des ersten Transistors T11, T21 und dem Steuereingang des zweiten Transistors T12, T22 angeordnet ist. Zur Verhinderung eines zu schnellen Potentialausgleiches zwischen dem Steuereingang des zweiten Transistors T12, T22 und dem ersten Versorgungspotential VDD1 ist zwischen dem Steuereingang der zweiten Transistoren T12, T22 und dem ersten Versorgungspotential VDD1 jeweils ein Widerstand R1, R2 angeordnet. Parallel zu dem Widerstand R1, R2 sind jeweils zwei antiparallel geschaltete Dioden D11, D12, D21, D22 als erste Klemmschaltung K1 und zweite Klemmschaltung K2 zur Klemmung auf das erste Versorgungspotential VDD1 vorgesehen.

Das Eingangssignal in ist dem ersten Transistor T11 der ersten Eingangsstufe 10 durch einen ersten Inverter 11 invertiert sowie dem ersten Transistor T21 der zweiten Eingangsstufe 20 durch einen zweiten Inverter 12 ein zweites Mal invertiert, also normal zugeführt.

Zwischen der Eingangsschaltung 1 und der Ausgangsschaltung 2 sind weitere Transistoren R3, R4 zur Begrenzung eines zwischen den Schaltungen fließenden Stromes angeordnet.

Die Ausgangsschaltung 2 ist durch zwei kreuzverkoppelte, dritte Transistoren T13, T23, die als p-Kanal-Transistoren ausgebildet sind, gebildet. Die dritten Transistoren T13, T23 sind in Source-Schaltung angeordnet, wobei am Drain-Anschluss des einen dritten Transistors T13, der mit der ersten Eingangsstufe 10 verbunden ist, das Ausgangssignal out direkt und am Drain-Anschluss des anderen dritten Transistors T23, der mit der zweiten Eingangsstufe 20 verbunden ist, ein invertiertes Ausgangssignal outq abgreifbar ist. Das invertierte Ausgangssignal outq ist durch eine erste Klemmdiode D1 und eine zweite Klemmdiode D2 auf den zweiten Betriebsspannungsbereich II geklemmt, wobei die erste Klemmdiode D1 auf das zweite Versorgungspotential VDD2 und die zweite Klemmdiode D2 auf das zweite Grundpotential VSS2 klemmt. Der Ausgangsschaltung 2 ist ein dritter Inverter I3 nachgeschaltet, so dass an einem Ausgang des dritten Inverters I3 das Ausgangssignal out abgreifbar ist.

Zur Vermeidung von großen Potentialdifferenzen zwischen dem ersten Grundpotential VSS1 und dem zweiten Grundpotential VSS2 sind zwischen dem ersten Grundpotential VSS1 und dem zweiten Grundpotential VSS2 zwei antiparallel geschaltete Dioden D3, D4, die auch als entsprechend als Diode geschaltete MOS-Transistoren ausgebildet sein können, geschaltet.

Die Potentialdifferenzen zwischen dem Grundpotential VSS1, VSS2 und dem Versorgungspotential VDD1, VDD2 in den jeweiligen Betriebsspannungsbereichen 1, 2 sind durch entsprechend angeordnete weitere Klemmschaltungen C11, C12, die zwischen das jeweilige Grundpotential VSS1, VSS2 und das jeweilige Versorgungspotential VDD1, VDD2 geschaltet sind beschränkt.

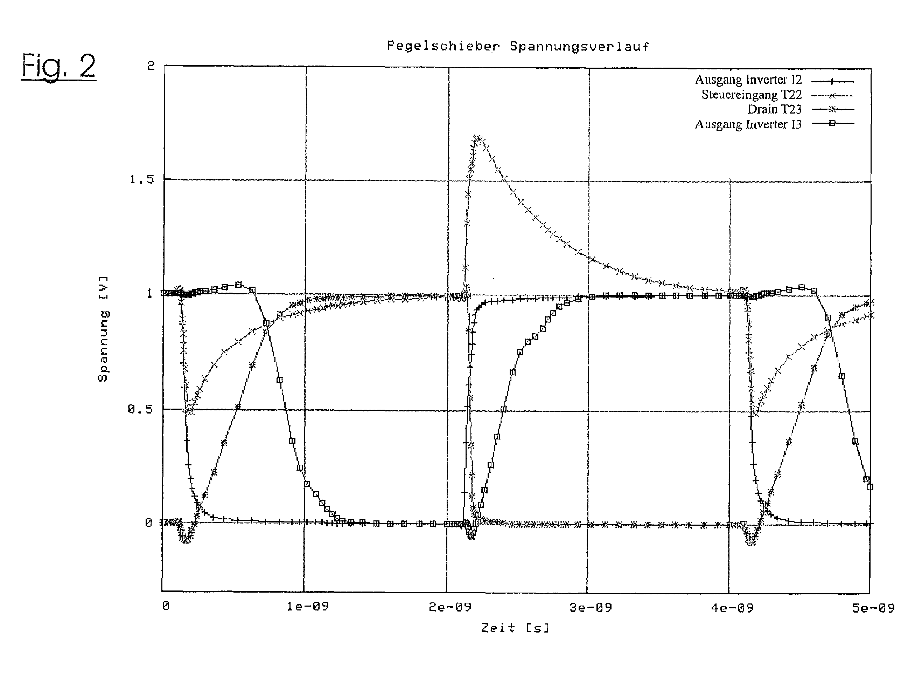

Die Funktion des oben beschriebenen Pegelschiebers wird nachfolgend unter Bezugnahme auf die in Figur 2 dargestellten Spannungsverläufe beispielhaft an einem Übergang des Eingangssignals in von einem low-Pegel zu einem high-Pegel erläutert.

Figur 2 zeigt dazu entsprechende Spannungsverläufe an den Ausgängen des zweiten und dritten Inverters I2, I3 am Steuereingang des zweiten Transistors T22 der zweiten Eingangsstufe 20 sowie am Drain-Anschluss des dritten Transistors T23. Der erste Betriebsspannungsbereich I ist dazu beispielhaft mit einer Grundspannung von 0 V und einer Versorgungsspannung von 1 V angegeben.

Das Ausgangssignal des Inverters I2 beschreibt dabei das zweifach invertierte Eingangssignal in, das dem ersten Transistor T21 der zweiten Eingangsstufe 20 angelegt ist. Am Drain-Anschluss des dritten Transistors T23 ist das invertierte Ausgangssignal outq abgreifbar, das dann am Ausgang des Inverters I3 als Ausgangssignal out abgreifbar ist.

Liegt am Ausgang des zweiten Inverters I2 ein Übergang von einem low-Pegel (0 V) zu einem high-Pegel (10) vor, so werden über die kapazitive Kopplung durch die Kapazität C2 Ladungen zum Steueranschluss des zweiten Transistors T22 geschoben. Der Steueranschluss des zweiten Transistors T22 liegt standardmäßig auf dem ersten Versorgungspotential VSS1 und wird durch die zusätzlichen Ladungen von der Kapazität C2 kurzfristig über das erste Versorgungspotential VSS1 angehoben, wodurch der zweite Transistor T22 in einen leitenden Zustand versetzt wird und gemeinsam mit dem ebenfalls leitenden ersten Transistor T21 den Drain-Anschluss des dritten Transistors T23 in Richtung des ersten Grundpotentials VDD1 zieht. Am Drain-Anschluss des dritten Transistors T23 ist damit ein low-Pegel abgreifbar, der durch den dritten Inverter I3 in einen high-Pegel, der als Ausgangssignal out abgreifbar ist, verwandelt wird.

Wie aus Figur 2 deutlich ersichtlich ist, wird das Potential am Eingang des zweiten Transistors T22 bei Schalten des Eingangssignals in von einem high-Pegel zu einem low-Pegel um etwa 0,5 V unterhalb das erste Versorgungspotential VDD1 abgesenkt wohingegen beim Schalten von einem low-Pegel zu einem high-Pegel das Eingangspotential des zweiten Transistors T22 um etwa 0,7 V anhebt. Zwischen den Signalwechseln stellt sich das Eingangspotential des zweiten Transistors in Form einer Lade- bzw. Entladekurve für den Kondensator C2 wieder auf den Wert des ersten Versorgungspotentials VDD1 ein.

Durch die beschriebene dynamische Toransteuerung kann eine Gate-Source-Spannung V_{GS} der zweiten Transistoren T12, T22 derart erhöht werden, dass eine effektive Gate-Spannung Veff_{G} der zweiten Transistoren T12, T22 ausreichend groß ist um diese trotz einer technologisch bedingten erhöhten Schwellspannung Vₜₕ in einen leitenden Zustand zu versetzen.

### Bezugszeichenliste

- T1: erster Eingangstransistor
- T2: zweiter Eingangstransistor
- T3: erster Ausgangstransistor
- T4: zweiter Ausgangstransistor
- T11/T21: erster Transistor
- T12/T22: zweiter Transistor
- T13/T23: dritter Transistor
- T14/T24: vierter Transistor
- T15/T25: fünfter Transistor

- D1: erste Klemmdiode
- D2: zweite Klemmdiode
- D3: dritte Klemmdiode
- D4: vierte Klemmdiode
- D11: erste Diode
- D12: zweite Diode
- D21: dritte Diode
- D22: vierte Diode

- I1: erster Inverter
- I2: zweiter Inverter
- I3: dritter Inverter

- in: Eingangssignal
- out: Ausgangssignal
- inq: invertiertes Eingangssignal
- outq: invertiertes Ausgangssignal

- 10: erste Eingangsstufe
- 10: erste Eingangsstufe
- 20: zweite Eingangsstufe

- I: erster Betriebsspannungsbereich
- II: zweiter Betriebsspannungsbereich

- 1: Eingangsschaltung
- 2: Ausgangsschaltung

- C11: erste Betriebsspannungs-Klemmschaltung
- C12: zweite Betriebsspannungs-Klemmschaltung

- K1: erste Klemmschaltung
- K2: zweite Klemmschaltung

- R1: erster Widerstand
- R2: zweiter Widerstand
- R3: dritter Widerstand
- R4: vierter Widerstand

- VDD1: erstes Versorgungspotential
- VDD2: zweites Versorgungspotential
- VSS1: erstes Betriebspotential
- VSS2: zweites Betriebspotential

- C1: erster Kondensator
- C2: zweiter Kondensator

## Patentansprüche

1. Pegelschieber zum Umsetzen eines Eingangssignals (in) aus einem ersten Betriebsspannungsbereich (I) mit einem ersten Grundpotential (VSS1) und einem ersten Betriebspotential (VDD1) in ein Ausgangssignal (out) in einem zweiten Betriebsspannungsbereich (II) mit einem zweiten Grundpotential (VSS2) und einem zweiten Betriebspotential (VDD2) mit einer Eingangsschaltung (1) an die das Eingangssignal (in) anlegbar ist und einer Ausgangsschaltung (2) an der das Ausgangssignal (out) abgreifbar ist, wobei die Eingangsschaltung (1) eine Parallelschaltung aus einer ersten Kaskode-Schaltung (10) und eine zweiten Kaskode-Schaltung (20) aufweist und die Kaskode-Schaltungen (10, 20) je aus einem ersten Transistor (T11, T21) in Source-Schaltung und einem zweiten Transistor (T12, T22) in Gate-Schaltung aufgebaut sind,
**dadurch gekennzeichnet, dass**
eine dynamische Ansteuerung für die zweiten Transistoren (T12, T22) vorgesehen ist.

2. Pegelschieber nach Anspruch 1,
**dadurch gekennzeichnet, dass**
bei den Kaskode-Schaltungen (10, 20) zwischen einem Steueranschluss des ersten Transistors (T11, T21) und einem Steueranschluss des zweiten Transistors (T12, T22) je eine Kapazität (C1, C2) angeordnet ist.

3. Pegelschieber nach Anspruch 1 oder 2,
**dadurch gekennzeichnet, dass**
zwischen dem Steueranschluss des jeweils zweiten Transistors (T12, T22) und dem ersten Betriebspotential (VDD1) je ein Widerstand (R1, R2) angeordnet ist.

4. Pegelschieber nach Anspruch 3,
**dadurch gekennzeichnet, dass**
der Steueranschluss des jeweils zweiten Transistors (T12, T22) mittels je einer Klemmschaltung (K1, K2) auf das erste Betriebspotential (VDD1) klemmt.

5. Pegelschieber nach Anspruch 4,
**dadurch gekennzeichnet, dass**
als Klemmschaltung (K1, K2) je zwei antiparallel geschaltete Dioden (D11, D12, D21, D22) parallel zu den Widerständen (R1, R2) vorgesehen sind.

6. Pegelschieber nach Anspruch 5,
**dadurch gekennzeichnet, dass**
die Dioden (D11, D12, D21, D22) durch MOS-Transistoren realisiert sind.

7. Pegelschieber nach einem der vorhergehenden Ansprüche,
**dadurch gekennzeichnet, dass**
die ersten Transistoren (T11, T21) für den ersten Betriebsspannungsbereich (I) geeignet sind und die zweiten Transistoren (T12, T22) für den zweiten Betriebsspannungsbereich (II) geeignet sind.

8. Pegelschieber nach einem der vorhergehenden Ansprüche,
**dadurch gekennzeichnet, dass**
vor der Eingangsschaltung (1) und/oder nach der Ausgangsschaltung (2) Inverter (I1, I2, I3) vorgesehen sind.

9. Pegelschieber nach einem der Ansprüche 2 bis 8,
**dadurch gekennzeichnet, dass**
die Kapazitäten (C1, C2) durch Gate-Kapazitäten von MOS-Transistoren gebildet sind.

10. Pegelschieber nach einem der Ansprüche 2 bis 8,
**dadurch gekennzeichnet, dass**
die Kapazitäten (C1, C2) durch Metallfinger- oder MIM-Kondensatoren gebildet sind.

11. Pegelschieber nach einem der Ansprüche 3 bis 10,
**dadurch gekennzeichnet, dass**
die Widerstände (R1, R2) durch Polysilizium-Widerstände gebildet sind.

12. Pegelschieber nach einem der Ansprüche 3 bis 10,
**dadurch gekennzeichnet, dass**
die Widerstände (R1, R2) durch Diffusions- oder Wannen-Widerstände gebildet sind.

13. Pegelschieber nach einem der vorhergehenden Ansprüche,
**dadurch gekennzeichnet, dass**
die Eingangsschaltung (1) und die Ausgangsschaltung (2) Schutzschaltungen (C11, C12, D1, D2, D3, D4) gegen elektrostatische Zerstörung aufweisen.

14. Pegelschieber nach einem der vorhergehenden Ansprüche,
**dadurch gekennzeichnet, dass** zwischen dem ersten Grundpotential (VSS1) und dem zweiten Grundpotential (VSS2) zwei antiparallel geschaltete Dioden (D3, D4) vorgesehen sind.

15. Pegelschieber nach einem der vorhergehenden Ansprüche,
**dadurch gekennzeichnet, dass** zwischen der Eingangsschaltung (1) und der Ausgangsschaltung (2) Widerstände (R3, R4) zur Strombegrenzung vorgesehen sind.
